# EUROPEAN PATENT APPLICATION

(11) **EP 2 703 948 A1**
(43) Date of publication of application: **05.03.2014**
(21) Application number: 12776224.3
(22) Date of filing: 26.04.2012
(51) Int. Cl.: G06F 3/01, G06F 3/033, G06F 3/038, G06F 3/048, G09G 5/00, G09G 5/36

(54) **ELECTRONIC DEVICE**

(30) Priority: 27.04.2011 JP 2011099186; 24.04.2012 JP 2012098438
(71) Applicant: Panasonic Corporation, Osaka 571-8501 (JP)
(72) Inventor: IKEMOTO, Koichi, Osaka-shi, Osaka 540-6207 (JP); FUKUTANI, Junichi, Osaka-shi, Osaka 540-6207 (JP); HIRABAYASHI, Yoshitaka, Osaka-shi, Osaka 540-6207 (JP)
(74) Representative: Vigand, Philippe
(86) International application number: PCT/JP2012/002852
(87) International publication number: WO 2012/147349

(57) **Abstract**

An electronic device includes a housing having a display, an angular velocity sensor, an acceleration sensor, and a controller. The angular velocity sensor detects an angular velocity around the X axis parallel to the display. The acceleration sensor detects an acceleration along the Z axis, which is perpendicular to the display and orthogonal to the X axis. The controller performs a first process when the angular velocity sensor detects a positive angular velocity first and then detects a negative angular velocity, and the acceleration sensor detects a change in the acceleration along the Z axis. The controller, on the other hand, performs a second process when the angular velocity sensor detects a negative angular velocity first and then detects a positive angular velocity, and the acceleration sensor detects a change in the acceleration along the Z axis.

## Description

### TECHNICAL FIELD

The present invention relates to an electronic device that includes an angular velocity sensor to achieve the functions of allowing the user to read electronic books, displaying images, and reproducing music or videos.

### BACKGROUND ART

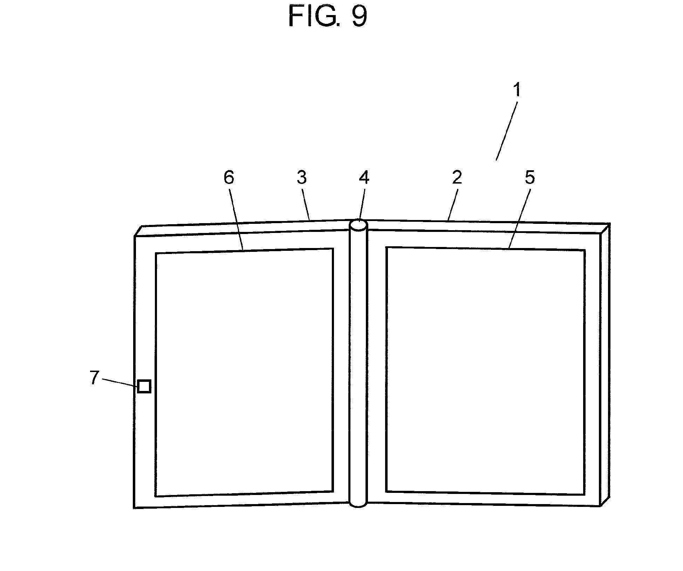

Fig. 9 is an external view of conventional electronic device 1. Electronic device 1 includes right body part 2, left body part 3, opening and closing shaft 4 connecting right and left body parts 2 and 3 openably and closably, and acceleration-and-angular velocity sensor 7. Right body part 2 includes right-side LCD unit 5, and left body part 3 includes left-side LCD unit 6 to display books, images, etc. Electronic device 1 further includes a controller (not shown), which detects the opening and closing angle between right body part 2 and left body part 3 according to an acceleration or angular velocity detected by acceleration-and-angular velocity sensor 7. The controller also determines the direction in which a large acceleration is generated when electronic device 1 is opened or closed, and then performs a process to turn pages forward or backward (cf. Patent Literature 1).

### Citation List

### Patent Literature

PLT 1: Japanese Unexamined Patent Publication No. 2009-217415

### SUMMARY OF THE INVENTION

The electronic device of the present invention includes a housing having a display, an angular velocity sensor, an acceleration sensor, and a controller. The angular velocity sensor detects an angular velocity around the X axis parallel to the display. The acceleration sensor detects an acceleration along the Z axis, which is perpendicular to the display and orthogonal to the X axis. The controller performs a first process when the angular velocity sensor detects a positive angular velocity first and then detects a negative angular velocity, and the acceleration sensor detects an acceleration along the Z axis. The controller, on the other hand, performs a second process when the angular velocity sensor detects a negative angular velocity first and then detects a positive angular velocity, and the acceleration sensor detects an acceleration along the Z axis.

The above configuration allows different processes to be performed depending on the order of occurrence of an angular velocity in the positive direction and an angular velocity in the negative direction when the housing is rotated. The above configuration also ensures detection of the rotation of the housing, allowing the first and second processes to be performed only when the detection is ensured. As a result, the user can operate the electronic device accurately with one hand in the environment where an acceleration or an angular velocity can occur due to vibration.

### BRIEF DESCRIPTION OF DRAWINGS

Fig. 1 is a perspective view of an electronic device according to a first exemplary embodiment of the present invention.
Fig. 2 is a block diagram of the electronic device shown in Fig. 1.
Fig. 3A shows output waveforms of an angular velocity sensor in the electronic device shown in Fig. 1.
Fig. 3B shows output waveforms of an acceleration sensor in the electronic device shown in Fig. 1.
Fig. 4 is a process flowchart of the electronic device shown in Fig. 1.
Fig. 5 is another process flowchart of the electronic device shown in Fig. 1.
Fig. 6A shows output waveforms of an angular velocity sensor and an acceleration sensor in an electronic device according to a second exemplary embodiment of the present invention.
Fig. 6B shows output waveforms of the angular velocity sensor and the acceleration sensor in the electronic device according to the second exemplary embodiment of the present invention.
Fig. 7 shows output waveforms of an angular velocity sensor and an acceleration sensor in an electronic device according to a third exemplary embodiment of the present invention.
Fig. 8A is a plan view of an electronic device according to a fourth exemplary embodiment of the present invention.
Fig. 8B is a block diagram of the electronic device shown in Fig. 8A.
Fig. 9 is a perspective view of a conventional electronic device.

### DESCRIPTION OF EMBODIMENTS

In recent years, portable electronic devices such as mobile phones, electronic book readers, and tablet terminals are becoming popular which allow the user to read books, display images, and reproduce music and videos. Such a portable electronic device is required to allow the user to operate it accurately with one hand in the environment where an acceleration or an angular velocity can occur due to vibration while, for example, he/she is walking with the other hand holding a bag, or riding in a train with the other hand hanging on to a strap.

In electronic device 1 shown in Fig. 9, however, pages are turned forward or backward based on the opening and closing angle and acceleration. Therefore, in the environment where an acceleration or an angular velocity can occur due to vibration, the user cannot accurately operate electronic device 1 with one hand.

The electronic device developed to solve the aforementioned problem will now be described with reference to drawings. In these embodiments, the same components as in the preceding embodiments are denoted by the same reference numerals, and thus a detailed description thereof may be omitted in the subsequent embodiments.

### (FIRST EXEMPLARY EMBODIMENT)

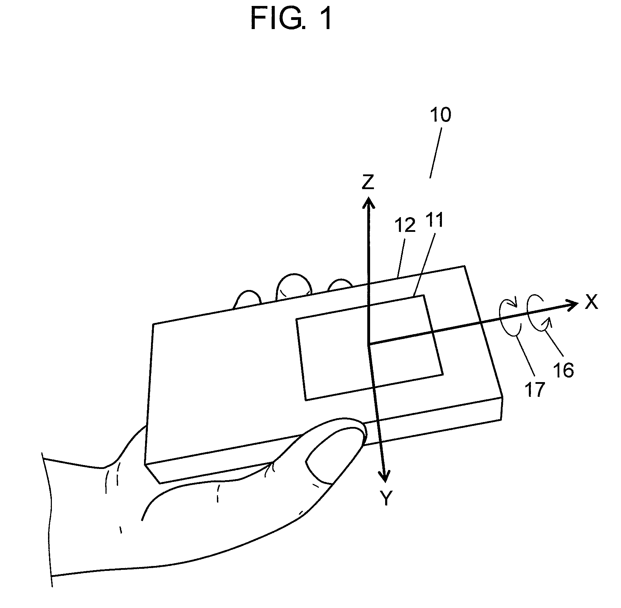

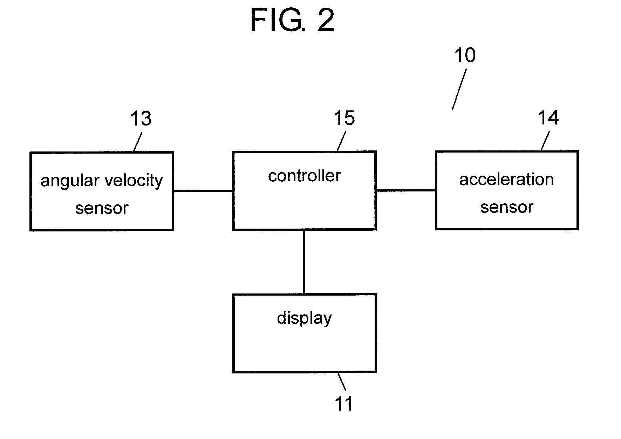

Fig. 1 shows electronic device 10 according to a first exemplary embodiment of the present invention. Fig. 2 is a block diagram of electronic device 10. Electronic device 10 includes housing 12 having display 11, angular velocity sensor 13, and controller 15. Angular velocity sensor 13 detects an angular velocity around the X axis which is parallel to display 11. Controller 15 performs a first process or a second process depending on the output of angular velocity sensor 13. More specifically, controller 15 performs the first process when angular velocity sensor 13 detects positive angular velocity 16 first and then detects negative angular velocity 17. Controller 15, on the other hand, performs the second process when angular velocity sensor 13 detects negative angular velocity 17 first and then detects positive angular velocity 16. Note that when the user is holding electronic device 10 in one hand, positive angular velocity 16 is in a clockwise direction, whereas negative angular velocity 17 is in a counterclockwise direction.

Thus, controller 15 can perform different processes depending on the order of occurrence of an angular velocity in the positive direction (positive angular velocity 16) and an angular velocity in the negative direction (negative angular velocity 17) when housing 12 is rotated. This allows the user to accurately operate electronic device 10 with one hand in the environment where an acceleration or an angular velocity can occur due to vibration.

Electronic device 10 further includes acceleration sensor 14 which can detect an acceleration along the Y axis. Controller 15 performs the first process when acceleration sensor 14 detects an acceleration in the positive direction of the Y axis, and angular velocity sensor 13 detects a positive angular velocity first and then detects a negative angular velocity. Controller 15, on the other hand, performs the second process when acceleration sensor 14 detects an acceleration in the negative direction of the Y axis, and angular velocity sensor 13 detects a negative angular velocity first and then detects a positive angular velocity. This control can further improve the accuracy of operation of electronic device 10.

Specific examples of electronic device 10 include mobile phones, electronic book readers, tablet terminals, and other portable electronic devices allowing the user to read electronic books (hereinafter, books), displaying images, and reproducing music (musical compositions) or videos.

When electronic device 10 has the function of displaying books for the user to read, the first process may be to turn pages of a book forward, and the second process may be to turn pages of the book backward. When electronic device 10 is displaying the front cover of a book, the first process may be to display the next book, and the second process may be to display the preceding book.

When electronic device 10 has the function of displaying one of a plurality of sequential images at a time, the first process is to display the image following the currently displayed image, and the second process is to display the image preceding the currently displayed image. Alternatively, when an image is displayed partially, the first process may be to display an undisplayed right side, and the second process may be to display an undisplayed left side.

When electronic device 10 has the function of reproducing a plurality of sequential musical compositions or videos, the first process is to reproduce the next musical composition or video, and the second process is to reproduce the preceding musical composition or video. Alternatively, the first process may be to fast-forward, and the second process may be to rewind (review).

The content of electronic books, images, musical compositions, etc. is stored in a storage unit connected to controller 15 but not shown. Alternatively, the content may be stored in an external storage unit connected via wiring and/or wirelessly to storage unit 15. The external storage unit may be connected to controller 15 via the Internet and wiring and/or wirelessly.

The following is a specific description of a control using angular velocity sensor 13 and acceleration sensor 14. Angular velocity sensor 13 and acceleration sensor 14 are configured to output angular velocities and accelerations, respectively, around the axes corresponding to the X, Y, and Z axes shown in Fig. 1. Such sensors are disclosed, for example, in Japanese Unexamined Patent Publication Nos. 2010-230346 and H11-352143. It is not, however, necessary to use a three-axis type sensor as long as the sensor meets the use application of each exemplary embodiment.

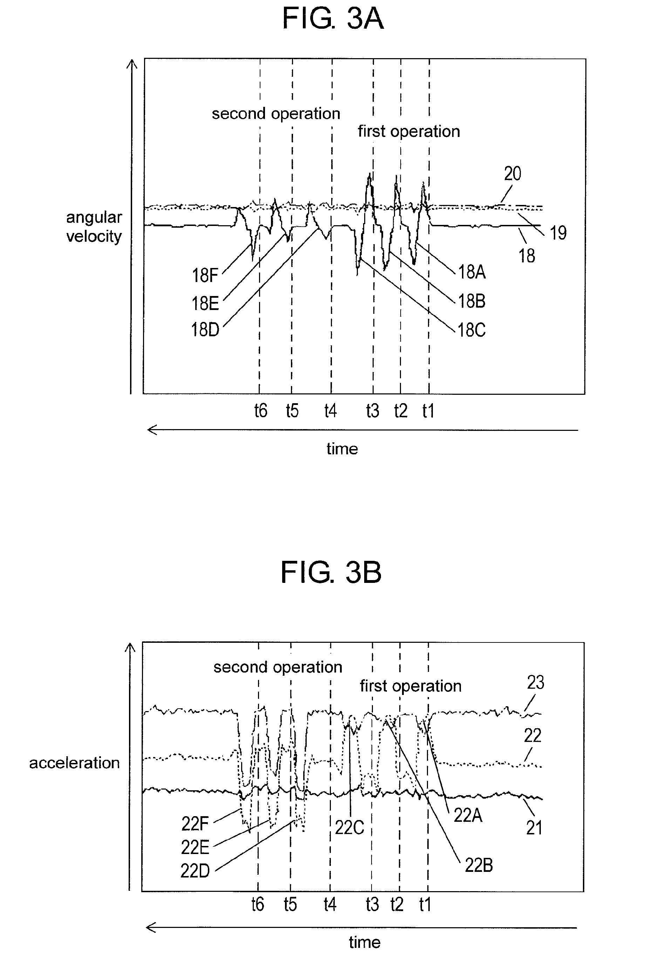

Figs. 3A and 3B show the measurement results of angular velocity sensor 13 and acceleration sensor 14, respectively. More specifically, these graphs show the outputs of angular velocity sensor 13 and acceleration sensor 14 around the X, Y, and Z axes shown in Fig. 1.

In Fig. 3A, the horizontal axis represents time, and the vertical axis represents angular velocity. Note that time increases from right to left. Fig. 3A shows fluctuations in angular velocity 18 around the X axis, in angular velocity 19 around the Y axis, and in angular velocity 20 around the Z axis.

A "first operation" is defined as follows. The user holds housing 12 in the right hand with display 11 facing upward (in the positive direction of the Z axis); rotates housing 12 in the positive direction (clockwise direction) of the X axis first; and then rotates it in the negative direction (counterclockwise direction) to return it to the original position. As shown in Fig. 3A, the "first operation" is performed three times at times t1, t2, and t3 as shown by waveforms 18A, 18B, and 18C, respectively.

A "second operation" is defined as follows. The user holds housing 12 in the right hand with display 11 facing upward (in the positive direction of the Z axis); rotates housing 12 in the negative direction (counterclockwise direction) of the X axis first; and then rotates it in the positive direction (clockwise direction) to return it to the original position. As shown in Fig. 3A, the "second operation" is performed three times at times t4, t5, and t6 as shown by waveforms 18D, 18E, and 18F, respectively.

As shown in Fig. 3A, in the "first operation", the positive angular velocity is detected first and then the negative angular velocity is detected. In the "second operation", the negative angular velocity is detected first and then the positive angular velocity is detected. The reason for this is that when the user operates electronic device 10 provided with display 11, he/she inevitably turns display 11 face up in the end in order, for example, to read a book displayed thereon.

It is possible to perform a predetermined process by only using the angular velocity in the case that housing 12 is rotated in a single direction, either positive or negative. More specifically, the first process can be performed when an angular velocity in the positive direction is detected, and the second process can be performed when an angular velocity in the negative direction is detected. In this case, however, when the user is operating electronic device 10 with one hand, while walking with the other hand holding a bag or riding in a train with the other hand hanging on to a strap, controller 15 may falsely recognize the angular velocity caused by walking vibration or train vibration. As a result, the first or second process may be executed mistakenly.

As shown in Fig. 3A, however, the user's intended operation always involves turning display 11 face up. Therefore, executing a process by considering this returning operation can prevent false (unwanted) operation due to walking or a train.

Thus, when angular velocity sensor 13 detects a positive angular velocity first and then detects a negative angular velocity, controller 15 determines that the "first operation" has been done purposefully by the user, and performs a first process. When, on the other hand, angular velocity sensor 13 detects a negative angular velocity first and then detects a positive angular velocity, controller 15 determines that the "second operation" has been done purposefully by the user, and performs a second process. These determinations prevent false operation due to the angular velocity caused by walking vibration or train vibration, allowing the user to accurately operate electronic device 10 with one hand.

Controller 15 may have a predetermined threshold for the angular velocity. If the absolute value of an angular velocity is equal to the threshold, controller 15 determines that the angular velocity has been detected, thereby further reducing the influence of the angular velocity caused by walking vibration or train vibration.

In Fig. 3B, the horizontal axis represents time, and the vertical axis represents acceleration. In the same manner as in Fig. 3A, time increases from right to left. Fig. 3B shows fluctuations in acceleration 21 along the X axis, along acceleration 22 along the Y axis, and along acceleration 23 along the Z axis. The time in the horizontal axis is the same between Figs. 3A and 3B.

Acceleration 22 along the Y axis shows waveforms 22A, 22B, and 22C that indicate accelerations in the positive direction at the times t1, t2, and t3, respectively, in the "first operation". Acceleration 22 further shows waveforms 22D, 22E, and 22F that indicate accelerations in the negative direction at the times t4, t5, and t6, respectively, in the "second operation".

When the user performs the "first operation", it is very difficult to rotate housing 12 while keeping it in the same position. Therefore, the user inevitably moves housing 12 in the positive direction along the Y axis. Similarly, when performing the "second operation", the user inevitably moves housing 12 in the negative direction along the Y axis. As a result, the waveforms shown in Fig. 3B are generated.

Making use of these features of the human body movement allows electronic device 10 to select the operation more accurately. More specifically, assume that acceleration sensor 14 detects an acceleration in the positive direction of the Y axis, and angular velocity sensor 13 detects a positive angular velocity first and then detects a negative angular velocity. In this case, controller 15 determines that the "first operation" has been done purposefully by the user, and performs the first process. Assume, on the other hand, that acceleration sensor 14 detects an acceleration in the negative direction of the Y axis, and angular velocity sensor 13 detects a negative angular velocity first and then detects a positive angular velocity. In this case, controller 15 determines that the "second operation" has been done purposefully by the user, and performs the second process. Thus, the "first operation" and the "second operation" can be distinguished from each other using acceleration, and also using angular velocity. This can prevent false operation, allowing electronic device 10 to select operations more accurately.

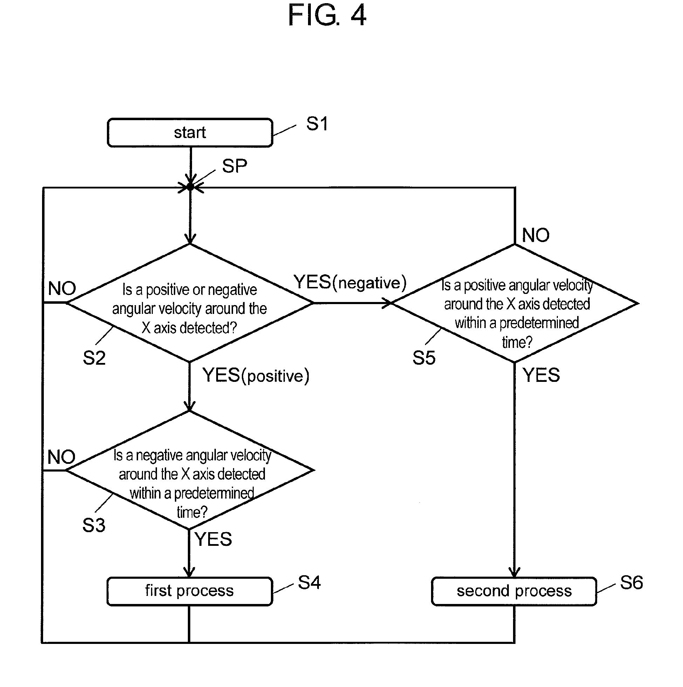

Fig. 4 is a process flowchart in which controller 15 performs a first process or a second process based on angular velocity sensor 13. In Step S1, the control is started. In Step S2, angular velocity sensor 13 detects a positive or negative angular velocity around the X axis. When no positive or negative angular velocity around the X axis is detected, the process returns to the starting point SP to restart detection of an angular velocity again.

When a positive angular velocity is detected in Step S2, the process proceeds to Step S3 where controller 15 determines whether or not a negative angular velocity around the X axis is detected within a predetermined time. When the negative angular velocity around the X axis is detected within the predetermined time, the process proceeds to Step S4 where controller 15 performs a first process. After this, the process returns to the starting point SP. When the negative angular velocity around the X axis is not detected within a predetermined time, the process directly returns to the starting point SP.

When, on the other hand, a negative angular velocity is detected in Step S2, the process proceeds to Step S5 where controller 15 determines whether or not a positive angular velocity around the X axis is detected within a predetermined time. When the positive angular velocity around the X axis is detected within a predetermined time, the process proceeds to Step S6 where controller 15 performs a second process. After this, the process returns to the starting point SP. When the positive angular velocity around the X axis is not detected within the predetermined time, the process directly returns to the starting point SP.

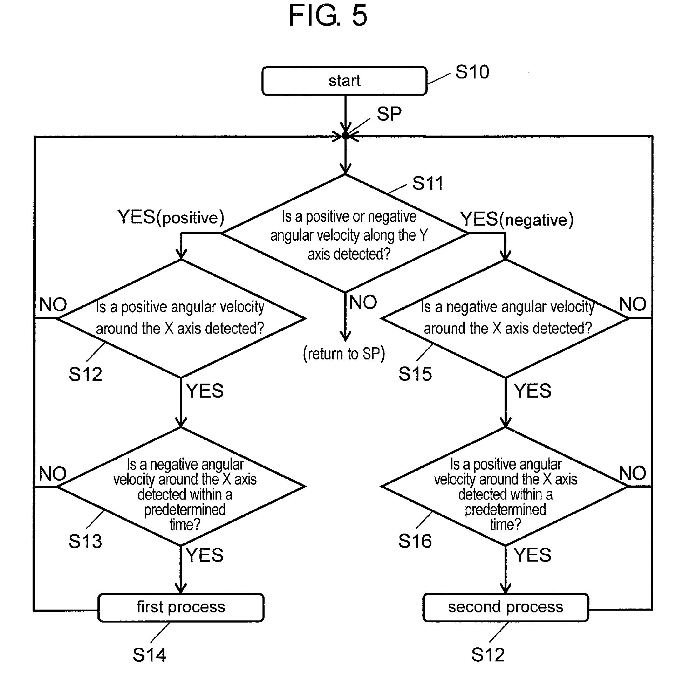

Fig. 5 is a process flowchart in which controller 15 performs a first process or a second process based on angular velocity sensor 13 and acceleration sensor 14. In Step S10, the control is started. In Step S11, acceleration sensor 14 detects a positive or negative acceleration. When no acceleration is detected, the process returns to the starting point SP to restart detection of an acceleration.

When a positive acceleration is detected in Step S11, the process proceeds to Step S12 where controller 15 determines whether or not angular velocity sensor 13 detects a positive angular velocity around the X axis. When the positive angular velocity around the X axis is not detected, the process returns to the starting point SP; otherwise, the process proceeds to Step S13.

In Step S13, controller 15 determines whether or not a negative angular velocity around the X axis is detected within a predetermined time. When the negative angular velocity is detected within the predetermined time, the process proceeds to Step S14 where a first process is performed. After this, the process returns to the starting point SP. When the negative angular velocity is not detected within a predetermined time, the process directly returns to the starting point SP.

When a negative acceleration is detected in Step S11, the process proceeds to Step S15 where controller 15 determines whether or not a negative angular velocity around the X axis is detected. When the negative angular velocity around the X axis is not detected, the process returns to the starting point SP; otherwise, the process proceeds to Step S16.

In Step S16, controller 15 determines whether or not a positive angular velocity around the X axis is detected within a predetermined time. When the positive angular velocity is detected within the predetermined time, the process proceeds to Step S17 where a second process is performed. After this, the process returns to the starting point SP. When the positive angular velocity is not detected within the predetermined time, the process directly returns to the starting point SP.

The predetermined times in Figs. 4 and 5 are determined to allow the user to complete a series of operations which begins with rotating electronic device 10 in the positive or negative direction and ends with rotating it in the opposite direction to return it to the original position. The predetermined times are preferably 0.1 seconds or more, which allows preventing false operation due to external disturbance such as impact that the user does not expect. It is also preferable that the predetermined times be within 2 seconds, which allows distinguishing between a first "first operation" and a second "first operation", and also distinguishing between a first "second operation" and a second "second operation".

In Fig. 4, the predetermined time in Step S3 may be different from that in Step S5. Similarly, in Fig. 5, the predetermined time in Step 13 may be different from that in Step S16. This provides the user with a different tactile feel between the "first operation" and the "second operation".

Alternatively, the predetermined times in Figs. 4 and 5 may be configured to be capable of being set by the user. In this case, each user can individually adjust the time required to recognize the "first operation" and the "second operation", thereby obtaining a comfortable operability.

In the present exemplary embodiment, the "first operation" and the "second operation" indicate lateral rotation of electronic device 10 (rotation around the X axis shown in Fig. 1) done by the user. These operations, however, may alternatively be longitudinal rotation of electronic device 10 (rotation around the Y axis shown in Fig. 1) to perform the first or second process.

### (SECOND EXEMPLARY EMBODIMENT)

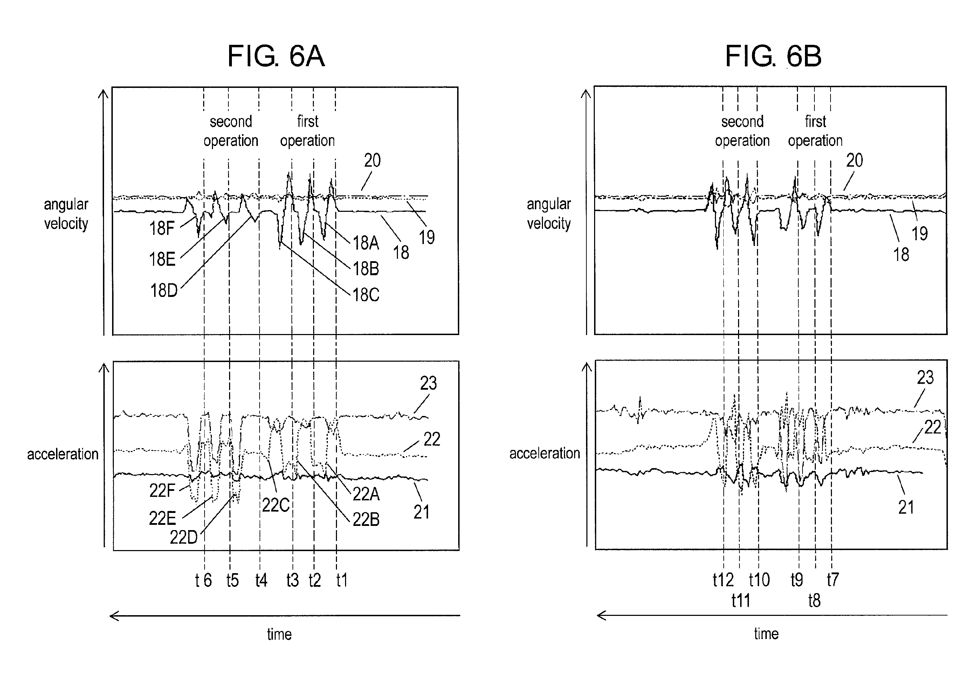

In the present exemplary embodiment, a control using an acceleration along the Z axis will now be described with reference to Figs. 1, 2, 6A, and 6B. Figs. 6A and 6B show comparative experimental results when the user holds housing 12 in the right hand and in the left hand, respectively. Note that electronic device 10 in the present exemplary embodiment has the same basic configuration as that in the first exemplary embodiment described with reference to Figs. 1 and 2.

Fig. 6A shows angular velocity and acceleration when the user performs the "first operation" and the "second operation" while holding housing 12 in the right hand as in Figs. 3A and 3B. Fig. 6B shows angular velocity and acceleration when the user performs the "first operation" and the "second operation" while holding housing 12 in the left hand.

As understood from Figs. 6A and 6B, the order of occurrence of positive and negative angular velocities 18 around the X axis, and the direction of generation of acceleration 22 along the Y axis are the same regardless of the hand in use. More specifically, as regards angular velocity 18 around the X axis, in the "first operation", a positive angular velocity is detected first and then a negative angular velocity is detected regardless of the hand in use. In the "second operation", a negative angular velocity is detected first and then a positive angular velocity is detected regardless of the hand in use. As regards acceleration 22 along the Y axis, in the "first operation", an acceleration in the positive direction is detected, whereas in the "second operation", an acceleration in the negative direction is detected regardless of the hand in use.

In contrast, acceleration 23 along the Z axis has a different waveform depending on the hand in use. When the user holds housing 12 in the right hand, acceleration 23 along the Z axis decreases only slightly in the "first operation", but greatly decreases in the "second operation". When the user holds housing 12 in the left hand, acceleration 23 along the Z axis greatly decreases in the negative direction in the "first operation", but decreases only slightly in the "second operation". The amount of rotation differs depending on whether the user is rotating housing 12 in his/her hand toward or away from his/her body. This seems to be the reason for the above-described waveforms of acceleration 23 along the Z axis.

In the initial state with display 11 facing upward, the Z-axis direction of electronic device 10 coincides with the direction of gravity. At this moment, the gravitational acceleration is at its maximum. The farther housing 12 is rotated around the X axis from this state, the larger the angle is between the Z-axis direction of electronic device 10 and the direction of gravity. This results in a decrease in the acceleration along the Z axis detected by acceleration sensor 14.

Because of the structure of the human arm, the amount of rotation is small when the user rotates housing 12 away from his/her body (the "first operation" when holding it in the right hand, the "second operation" when holding it in the left hand). The rotation away from his/her body corresponds to the "first operation" when the user holds housing 12 in the right hand, and corresponds to the "second operation" when the user holds housing 12 in the left hand. The small amount of rotation makes a small angle between the Z-axis direction of electronic device 10 and the direction of gravity, thereby only slightly reducing acceleration 23 along the Z axis. In contrast, the amount of rotation is larger when the user rotates housing 12 toward his/her body than when the user does it away from his/her body. The rotation toward his/her body corresponds to the "second operation" when the user holds housing 12 in the right hand, and corresponds to the "first operation" when the user holds housing 12 in the left hand. This large amount of rotation makes a large angle between the Z-axis direction of electronic device 10 and the direction of gravity, thereby greatly decreasing acceleration 23 along the Z axis.

As described above, controller 15 can determine which hand the user has used to operate electronic device 10 from the difference in the change of acceleration 23 along the Z axis due to the structure of the human arm.

Thus, controller 15 can detects the "first operation" or the "second operation" by using angular velocity 18 around the X axis and acceleration 22 along the Y axis around the X axis. Furthermore, when detecting the "first operation", controller 15 can determine it to be an operation done by the left hand if the change in acceleration 23 along the Z axis is below a predetermined threshold. If the change is not below the predetermined threshold, i.e. the change is equal to or more than the predetermined threshold, controller 15 can determine it to be an operation done by the right hand.

Similarly, when detecting the "second operation", controller 15 can determine it to be an operation done by the right hand if acceleration 23 along the Z axis is below the predetermined threshold. If the acceleration is not below the predetermined threshold, i.e. the acceleration is equal to or more than the predetermined threshold, controller 15 can determine it to be an operation done by the left hand.

Especially when electronic device 10 has game functions, controller 15 can provide different operations in games by determining which hand the user is using to operate it. In a baseball or golf game, for example, controller 15 can determine the dominant hand of the user from the hand used for the operation, and provide batting and pitching operations according to his/her dominant hand.

### (THIRD EXEMPLARY EMBODIMENT)

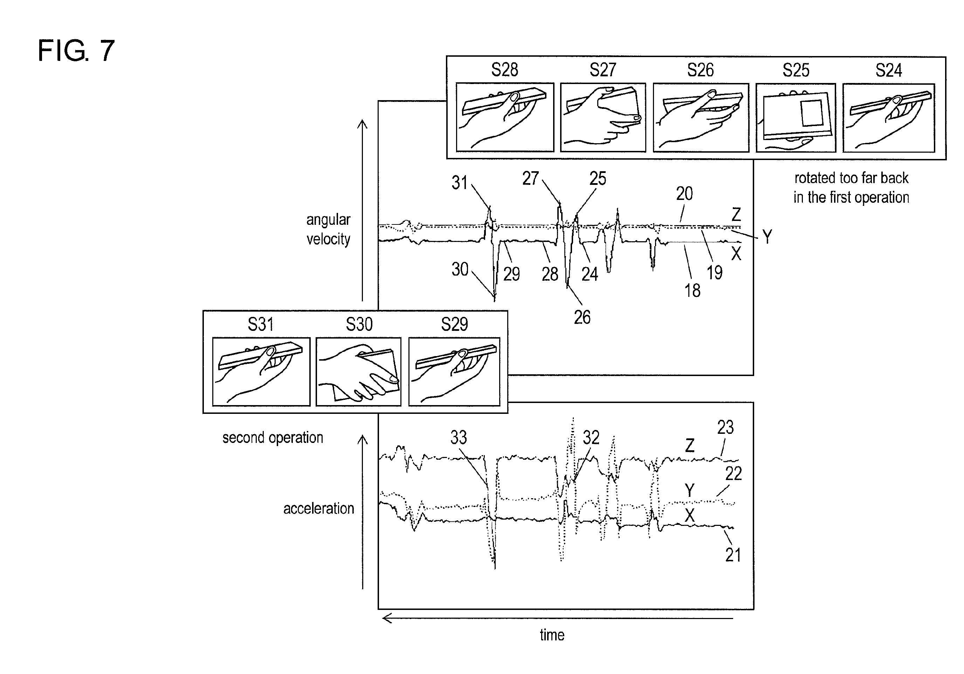

In the present exemplary embodiment, another control using acceleration 23 along the Z axis will be described with reference to Figs. 1, 2, and 7. Fig. 7 shows comparative experimental results indicating the difference between the case where the user rotates housing 12 in the right hand too far back in the "first operation" and the case where the user performs the "second operation". Note that electronic device 10 in the present exemplary embodiment has the same basic configuration as that in the first exemplary embodiment described with reference to Figs. 1 and 2.

In the "first operation", the user rotates electronic device 10 from the starting position shown in S24 in a clockwise direction as shown in S25, and rotates it back to the original position as shown in S26. If rotating electronic device 10 too far back as shown in S27, the user rotates it back again as shown in S28. These operations shown in S24 to S28 are represented by waveforms 24 to 28, respectively, of angular velocity 18 around the X axis.

In the "second operation", the user rotates electronic device 10 from the starting position shown in S29 in a counterclockwise direction as shown in S30, and rotates it back to the original position as shown in S31. These operations shown in S29 to S31 are represented by waveforms 29 to 31, respectively, of angular velocity 18 around the X axis.

The waveform resulting from the action of rotating back (S26) to the action of rotating back again (S28) in the "first operation" is substantially identical to the waveform resulting from the starting position (S29) to the action of rotating back (S31) in the "second operation". Therefore, it is very difficult to distinguish between these waveforms. As a result, controller 15 may falsely recognize the "first operation" performed by the user as the "second operation", thereby performing the second process.

However, the use of acceleration 23 along the Z axis can discriminate between the case where electronic device 10 is rotated too far back in the "first operation" and the case where the "second operation" is performed. As understood from Fig. 7, while waveform 32 shows a slight decrease in acceleration 23 along the Z axis in the "first operation", waveform 33 shows a large decrease in the "second operation". The reason for this seems to be the difference in the amount of rotation depending on whether the user rotates housing 12 purposefully or rotates it too far back unintentionally.

Consequently, even when a negative angular velocity is detected first and then a positive angular velocity is detected, if the change in acceleration 23 along the Z axis is not below the predetermined threshold, controller 15 can determine that housing 12 has been rotated too far back in the "first operation" and does not perform the second process.

Thus, even when angular velocity sensor 13 detects a positive angular velocity first and then detects a negative angular velocity, if the change in acceleration 23 along the Z axis is below the predetermined threshold, controller 15 performs the process occurring immediately before the detection of the negative angular velocity preferentially over the first process. Similarly, even when angular velocity sensor 13 detects a negative angular velocity first and then detects a positive angular velocity, if the change in acceleration 23 along the Z axis is below the predetermined threshold, controller 15 performs the process occurring immediately before the detection of the positive angular velocity preferentially over the second process. These controls prevent false operation due to rotating electronic device 10 too far back, thereby accurately detecting operations performed by the user with one hand.

In the second and third exemplary embodiments, controller 15 performs the first process when angular velocity sensor 13 detects positive angular velocity 16 first and then detects negative angular velocity 17, and acceleration sensor 14 detects a change in acceleration 23 along the Z axis. Controller 15, on the other hand, performs the second process when angular velocity sensor 13 detects negative angular velocity 17 first and then detects positive angular velocity 16, and acceleration sensor 14 detects a change in acceleration 23 along the Z axis. Thus, using the output of acceleration sensor 14 in addition to the output of angular velocity sensor 13 ensures detection of the "first operation" and the "second operation".

In Figs. 3A, 6A, 6B, and 7 referred to in the first to third exemplary embodiments, a positive value is output as a positive angular velocity, and a negative value is output as a negative angular velocity. Alternatively, however, a negative value may be output as a positive angular velocity, and a positive value may be output as a negative angular velocity because the polarity of the output signal of angular velocity sensor 13 is arbitrarily assigned. Similarly to the case of angular velocity, in Figs. 3B, 6A, 6B, and 7, a positive value is output as a positive acceleration, and a negative value is output as a negative acceleration. Alternatively, however, a negative value may be output as a positive acceleration, and a positive value may be output as a negative acceleration because the polarity of the output signal of acceleration sensor 14 is arbitrarily assigned.

### (FOURTH EXEMPLARY EMBODIMENT)

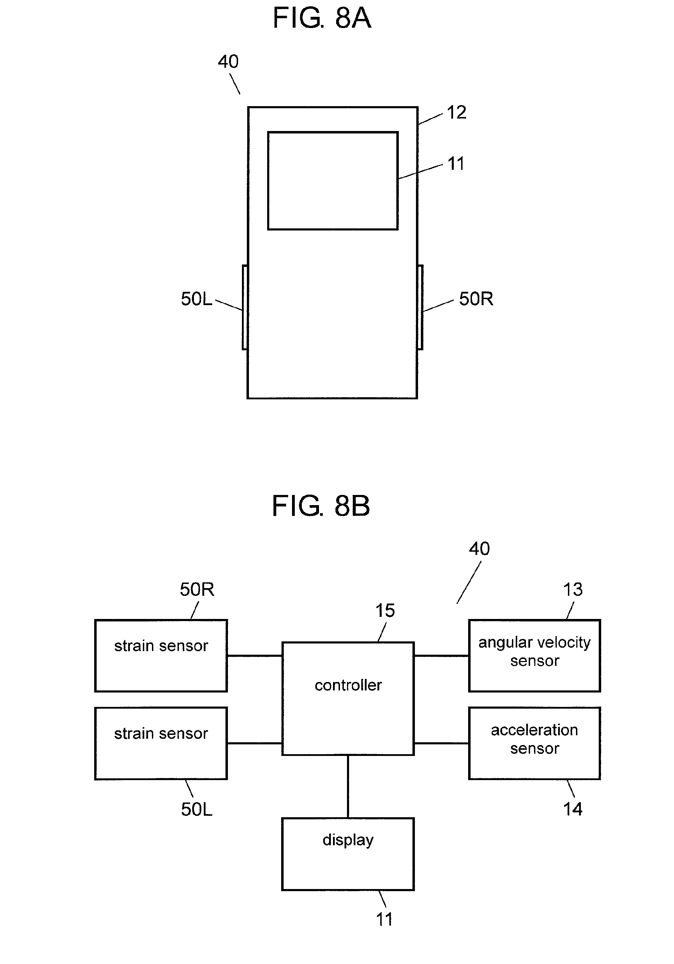

Fig. 8A is a plan view of an electronic device according to a fourth exemplary embodiment of the present invention. Fig. 8B is a block diagram of the electronic device shown in Fig. 8A.

Electronic device 40 includes strain sensors 50R and 50L on the right and left sides, respectively, of housing 12 in addition to the configuration of electronic device 10 shown in Figs. 1 and 2. The outputs of strain sensors 50R and 50L are fed to controller 15 in the same manner as the outputs of angular velocity sensor 13 and of acceleration sensor 14. Except for this feature, electronic device 40 has the same basic configuration as electronic device 10.

Strain sensors 50R and 50L are disposed in positions subjected to finger pressure or thumb pressure when the user holds electronic device 40. Assume that the user presses strain sensor 50R to create a strain when the user performs the "first operation". In this case, controller 15 detects this strain, and when, for example, the first process is to turn pages forward, the user can jump a plurality of pages forward at a time. Assume, on the other hand, that the user presses strain sensor 50L to create a strain when the user performs the "second operation". In this case, controller 15 detects this strain, and when, for example, the second process is to turn pages backward, the user can return a plurality of pages at a time. In other cases, a plurality of contents can be forwarded or returned in the selection of content such as images, musical compositions, and videos. In addition, the amount of content to be forwarded or returned can be increased or decreased depending on the magnitude of the strain. Note that this process can be performed without acceleration sensor 14.

If acceleration or angular velocity is accidentally applied to electronic device 10 while the user is carrying it in a bag with the power switch on, the first or second process may be performed without the user's knowledge. In contrast, when the user is holding electronic device 40 in his/her hand, strain sensors 50R and 50L are pressed, and detect generation of a strain having a reference value. If the outputs of strain sensors 50R and 50L are the reference value or greater, controller 15 determines that electronic device 40 is held in the user's hand. Therefore, it is preferable that controller 15 be configured to perform the first or second process if receiving an output based on an angular velocity around the X axis from angular velocity sensor 13 in this state. This control prevents the first or second process from being performed without the user's knowledge when, for example, electronic device 40 is in a bag with the power switch on.

Furthermore, while the user is rotating electronic device 40 around the X axis, the strains applied to strain sensors 50R and 50L are changed. Of strain sensors 50R and 50L, the lower one in position is subjected to more gravitational acceleration than the higher one. As a result, the higher one has a smaller strain, and the lower one has a larger strain. When, for example, electronic device 40 is rotated in a counterclockwise direction, strain sensor 50L has a larger output, and strain sensor 50R has a smaller output. Therefore, it is preferable that controller 15 be configured to calculate the difference in change from the reference value between the respective strain sensors (the difference value), and that controller 15 perform the first or second process when the absolute value of a difference of the difference values is equal to or more than the predetermined threshold. This control ensures the detection of rotation done by the user.

Alternatively, controller 15 may be configured to determine the direction of rotation depending on whether the difference value is positive or negative. This determination can be made without angular velocity sensor 13, but using both improves the accuracy of determining the direction of rotation.

Strain sensors 50R and 50L can detect comparatively as small a strain as is generated by finger pressure or thumb pressure, which is several tens of grams per square centimeter. One such strain sensor is disclosed in Japanese Unexamined Patent Publication No. 2007-085993.

In Fig. 8A, strain sensors 50R and 50L are disposed so as to project from housing 12, buy may alternatively be formed in the same plane as the side surfaces of housing 12. Further alternatively, housing 12 may cover strain sensors 50R and 50L as long as finger pressure or the like can reach these sensors via the side surfaces of housing 12. In this case, all or part of housing 12 may be made of a deformable material.

In Fig. 8A, strain sensors 50R and 50L are disposed on each side surface of housing 12; alternatively, however, a plurality of strain sensors may be disposed on each side surface of housing 12. Disposing a plurality of strain sensors on each side allows detection of strain distribution. When the user holds electronic device 40 in his/her hand, if housing 12 has a width fitting the palm, the thumb is placed on one of the side surfaces of housing 12, and at least two of the fingers are placed on the other side. In this case, while strain is concentrated in one region on the side where the thumb is placed, strain is dispersed in two or more regions on the other side. Detecting such strain distribution on each side surface allows controller 15 to determine which hand the user is using to hold electronic device 40, thereby providing advantageous effects similar to those of the second exemplary embodiment. In the case of using a strain sensor capable of detecting strain distribution, it is sufficient to use a single strain sensor 50R and a single strain sensor 50L.

### INDUSTRIAL APPLIABILITY

The electronic device of the present invention allows the user to operate it accurately with one hand in the environment where an acceleration or an angular velocity can occur due to vibration, and therefore, is useful as an electronic device that allows the user to read books, displays images and reproduces music or videos.

### REFERENCE MARKS IN THE DRAWINGS

- 10, 40: electronic device
- 11: display
- 12: housing
- 13: angular velocity sensor
- 14: acceleration sensor
- 15: controller
- 16: positive angular velocity
- 17: negative angular velocity
- 18: angular velocity around the X axis
- 18A, 18B, 18C, 18D, 18E, 18F: waveform
- 19: angular velocity around the Y axis
- 20: angular velocity around the Z axis
- 21: acceleration along the X axis
- 22: acceleration along the Y axis
- 22A, 22B, 22C, 22D, 22E, 22F: waveform
- 23: acceleration along the Z axis
- 24, 25, 26, 27, 28, 29, 30, 31, 32, 33: waveform
- 50R, 50L: strain sensor

## Claims

1. An electronic device comprising:
a housing having a display;
an angular velocity sensor capable of detecting an angular velocity around an X axis parallel to the display;
an acceleration sensor capable of detecting an acceleration along a Z axis, which is perpendicular to the display and orthogonal to the X axis;
a controller configured to perform a first process or a second process based on outputs of the angular velocity sensor and of the acceleration sensor,
wherein the controller performs the first process when the angular velocity sensor detects a positive angular velocity first and then detects a negative angular velocity, and the acceleration sensor detects a change in the acceleration along the Z axis; and
the controller performs the second process when the angular velocity sensor detects a negative angular velocity first and then detects a positive angular velocity, and the acceleration sensor detects a change in the acceleration along the Z axis.

2. The electronic device according to claim 1,
wherein the acceleration sensor is further capable of detecting an acceleration along a Y axis, which is parallel to the display and orthogonal to the X axis, and
the controller performs the first process when all of following conditions are satisfied:
the acceleration sensor detects an acceleration in a positive direction of the Y axis;
the angular velocity sensor detects the positive angular velocity first and then detects the negative angular velocity; and
the acceleration sensor detects the change in the acceleration along the Z axis, and
the controller performs the second process when all of following conditions are satisfied:
the acceleration sensor detects an acceleration in a negative direction of the Y axis;
the angular velocity sensor detects the negative angular velocity first and then detects the positive angular velocity; and
the acceleration sensor detects the change in the acceleration along the Z axis.

3. The electronic device according to claim 1, wherein
when the change in the acceleration along the Z axis, which is detected by the acceleration sensor, is below a predetermined threshold,
even if the angular velocity sensor detects the positive angular velocity first and then detects the negative angular velocity, the controller performs a process occurring immediately before detection of the negative angular velocity preferentially over the first process; and
even if the angular velocity sensor detects the negative angular velocity first and then detects the positive angular velocity, the controller performs a process occurring immediately before detection of the positive angular velocity preferentially over the second process.

4. The electronic device according to claim 1, wherein
when the housing is rotated in a positive direction of the X axis first and then rotated in a negative direction of the X axis,
the controller determines that the housing is rotated by a left hand when the change in the acceleration along the Z axis, which is detected by the acceleration sensor, is a predetermined threshold or greater; and
the controller determines that the housing is rotated by a right hand when the change in the acceleration along the Z axis is below the predetermined threshold.

5. The electronic device according to claim 1, wherein
when the housing is rotated in a negative direction of the X axis first and then rotated in a positive direction of the X axis,
the controller determines that the housing is rotated by a right hand when the change in the acceleration along the Z axis, which is detected by the acceleration sensor, is a predetermined threshold or greater; and
the controller determines that the housing is rotated by a left hand when the change in the acceleration along the Z axis is below the predetermined threshold.

6. The electronic device according to claim 1,
wherein the electronic device has a function of displaying electronic books for a user to read;
the first process is turning a page of an electronic book forward; and
the second process is turning a page of the electronic book backward.

7. The electronic device according to claim 1,
wherein the electronic device has a function of displaying one of a plurality of sequential images ;
the first process is to display an image following a currently displayed image; and
the second process is to display an image preceding the currently displayed image.

8. The electronic device according to claim 1,
wherein the electronic device has a function of reproducing a plurality of sequential musical compositions or videos;
the first process is to reproduce a next musical composition or video; and
the second process is to reproduce a preceding musical composition or video.
